# EUROPEAN PATENT APPLICATION

(11) **EP 3 273 496 A1**
(43) Date of publication of application: **24.01.2018**
(21) Application number: 16765015.9
(22) Date of filing: 16.03.2016
(51) Int. Cl.: H01L 51/44, H01L 51/46

(54) **SOLAR CELL**

(30) Priority: 16.03.2015 JP 2015052600; 16.03.2015 JP 2015052602
(71) Applicant: Sekisui Chemical Co., Ltd., Osaka-shi Osaka 530-0047 (JP)
(72) Inventor: UNO, Tomohito, Mishima-gun Osaka 618-0021 (JP); HAYAKAWA, Akinobu, Mishima-gun Osaka 618-0021 (JP); OHARA, Shunji, Mishima-gun Osaka 618-0021 (JP); YUKAWA, Mayumi, Mishima-gun Osaka 618-0021 (JP); ASANO, Motohiko, Mishima-gun Osaka 618-0021 (JP); FUKUMOTO, Yuuichirou, Mishima-gun Osaka 618-0021 (JP)
(74) Representative: Hart-Davis, Jason
(86) International application number: PCT/JP2016/058313
(87) International publication number: WO 2016/148186

(57) **Abstract**

The present invention aims to provide a solar cell excellent in high-temperature, high-humidity durability. The present invention aims to provide a solar cell including: a cathode; an anode; and a photoelectric conversion layer disposed between the cathode and the anode, the photoelectric conversion layer containing an organic-inorganic perovskite compound represented by the formula R-M-X₃ where R is an organic molecule, M is a metal atom, and X is a halogen atom or a chalcogen atom, at least one of the cathode and the anode having a resin layer disposed thereon, the resin layer having an inorganic layer disposed thereon, the resin layer having a glass transition temperature of 70°C or higher and 200°C or lower, and having a coefficient of linear expansion of 9.0 × 10⁻⁶K⁻¹ or greater and 1.5 × 10⁻⁴K⁻¹ or smaller.

## Description

### TECHNICAL FIELD

The present invention relates to solar cells excellent in high-temperature, high-humidity durability.

### BACKGROUND ART

Photoelectric conversion elements equipped with a laminate having an N-type semiconductor layer and a P-type semiconductor layer disposed between opposing electrodes have been conventionally developed. Such photoelectric conversion elements generate photocarriers by photoexcitation so that electrons and holes move through the N-type semiconductor and the P-type semiconductor, respectively, to create an electric field.

Most photoelectric conversion elements currently in practical use are inorganic solar cells which are produced using inorganic semiconductors such as silicon. The inorganic solar cells, however, have limited applications because they are costly to produce and difficult to upsize. Therefore, attention is given to organic solar cells produced using organic semiconductors instead of inorganic semiconductors, and organic solar cells produced using both inorganic semiconductors and organic semiconductors (see, e.g., Patent Literature 1).

In the organic solar cells, the cathode side or the anode side of a laminate having an N-type semiconductor layer and a P-type semiconductor layer disposed between opposing electrodes is generally encapsulated using a resin layer (see, e.g., Non-Patent Literature 1). However, such encapsulation with a resin layer alone does not provide sufficient durability. There thus has been a demand for enhanced durability.

### CITATION LIST

### - Patent Literature

Patent Literature 1: JP 2006-344794 A

### - Non-Patent Literature

Non-Patent Literature 1: Proc. of SPIE Vol. 7416 74160K-1

### SUMMARY OF INVENTION

### - Technical problem

The present invention aims to provide a solar cell excellent in high-temperature, high-humidity durability.

### - Solution to problem

The present invention provides a solar cell including: a cathode; an anode; and a photoelectric conversion layer disposed between the cathode and the anode, the photoelectric conversion layer containing an organic-inorganic perovskite compound represented by the formula R-M-X₃ where R is an organic molecule, M is a metal atom, and X is a halogen atom or a chalcogen atom, at least one of the cathode and the anode having a resin layer disposed thereon, the resin layer having an inorganic layer disposed thereon, the resin layer having a glass transition temperature of 70°C or higher and 200°C or lower, and having a coefficient of linear expansion of 9.0 × 10⁻⁶K⁻¹ or greater and 1.5 × 10⁻⁴K⁻¹ or smaller.

In the following, the present invention will be described in detail.

The present inventors considered the use of an organic-inorganic perovskite compound in a photoelectric conversion layer in a solar cell including a cathode, an anode, and a photoelectric conversion layer disposed between the cathode and anode. The use of an organic-inorganic perovskite compound is expected to lead to high photoelectric conversion efficiency. The present inventors also considered encapsulation by disposing a resin layer on at least one of the cathode and the anode and disposing an inorganic layer (by, for example, sputtering) on the resin layer so as to enhance the durability of the solar cell.

However, the inventors found that with some types of resin layers, fine surface protrusions and recesses (undulation) are formed in the inorganic layer and resin layer, especially in a high-temperature, high-humidity atmosphere at a humidity of about 85% or higher and a temperature of about 85°C or higher. They found that these fine surface protrusions and recesses (undulation) tend to cause cracking and peeling of the inorganic layer, leading to penetration of moisture inside the resin layer through these peeling and cracks to degrade the solar cell.

To overcome the situation, the present inventors found out the following: Adjusting the glass transition temperature and the coefficient of linear expansion of the resin layer in specific ranges reduces the formation of fine surface protrusions and recesses in the inorganic layer and the rein layer even in a high-temperature, high-humidity atmosphere, thus reducing peeling and cracking of the inorganic layer even in a high-temperature, high-humidity atmosphere. This enhances the high-temperature, high-humidity durability of the solar cell. The present inventors also found out that especially when the photoelectric conversion layer contains an organic-inorganic perovskite compound, the resin layer with the glass transition temperature and coefficient of linear expansion adjusted within specific ranges is less likely to peel from the photoelectric conversion layer. These findings led to the completion of the present invention.

The solar cell of the present invention includes a cathode, an anode, and a photoelectric conversion layer disposed between the cathode and the anode.

The term "layer" as used herein means not only a layer having a clear boundary, but also a layer having a concentration gradient in which contained elements are gradually changed. The elemental analysis of the layer can be conducted, for example, by FE-TEM/EDS analysis and measurement of the cross section of the solar cell to confirm the element distribution of a particular element. The term "layer" as used herein means not only a flat thin film-shaped layer, but also a layer capable of forming an intricate structure together with other layer(s). Herein, a range expressed as "A to B" means "A or greater but B or less".

The cathode and the anode may be made of any material, and conventionally known materials can be used. The anode in many cases is a patterned electrode.

Examples of cathode materials include fluorine-doped tin oxide (FTO), sodium, sodium-potassium alloy, lithium, magnesium, aluminum, magnesium-silver mixtures, magnesium-indium mixtures, aluminum-lithium alloy, Al/Al₂O₃ mixtures, and Al/LiF mixtures. Examples of anode materials include metals such as gold, conductive transparent materials such as CuI, indium tin oxide (ITO), SnO₂, aluminum zinc oxide (AZO), indium zinc oxide (IZO), and gallium zinc oxide (GZO), and conductive transparent polymers. These materials may be used alone or in combination of two or more thereof.

The cathode material may have any refractive index. In cases where the cathode contacts the resin layer, the difference in refractive index between the cathode material and the resin layer is preferably small. A reduction in the difference in refractive index between the resin layer and a material that contacts the resin layer (e.g., the cathode or anode, a substrate) allows sunlight to efficiently reach the inside of the solar cell (inside of the photoelectric conversion layer), which can enhances the photoelectric conversion efficiency of the solar cell. For example, FTO typically has a refractive index of about 1.9 or greater but 2.1 or less. ITO typically has a refractive index of about 1.8 or greater but 2.3 or smaller.

The anode material may also have any refractive index. Yet, in cases where the anode contacts the resin layer, the difference in refractive index between the anode material and the resin layer is preferably small. For example, indium tin oxide (ITO) typically has a refractive index of about 1.8 or greater but 2.3 or smaller. AZO typically has a refractive index of about 1.8 or greater but 2.2 or smaller.

The photoelectric conversion layer contains an organic-inorganic perovskite compound represented by the formula R-M-X₃ where R is an organic molecule, M is a metal atom, and X is a halogen atom or a chalcogen atom. The solar cell in which the photoelectric conversion layer contains the organic-inorganic perovskite compound may be referred to as an organic-inorganic hybrid solar cell.

The use of the organic-inorganic perovskite compound in the photoelectric conversion layer can enhance the photoelectric conversion efficiency of the solar cell. When the organic-inorganic perovskite compound is used in the photoelectric conversion layer, since the organic-inorganic perovskite compounds have low moisture resistance, disposing a resin layer and an inorganic layer (described later) on at least one of the cathode and the anode is more effective in enhancing the high-temperature, high-humidity durability of the solar cell.

The R is an organic molecule, and preferably represented by CₗNₘHₙ (l, m, and n are each a positive integer).

Specific examples of the R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azete, azole, imidaszoline, carbazole, and ions thereof (e.g., methylammonium (CH₃NH₃)), and phenethylammonium. Preferred among these are methylamine, ethylamine, propylamine, butylamine, pentylamine, hexylamine, and ions thereof, and phenethylammonium. More preferred are methylamine, ethylamine, propylamine, and ions thereof.

The M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used alone or in combination of two or more thereof.

The X is a halogen atom or a chalcogen atom. Examples thereof include chlorine, bromine, iodine, sulfur, and selenium. These halogen atoms or chalcogen atoms are used alone or in combination of two or more thereof. In particular, halogen atoms are preferred because the organic-inorganic perovskite compound containing halogen in the structure is soluble in organic solvents, and thus usable in inexpensive printing method or the like. Iodine is more preferred because the organic-inorganic perovskite compound has a narrow energy band gap.

The organic-inorganic perovskite compound preferably has a cubic structure where the metal atom M is placed at the body center, the organic molecule R is placed at each vertex, and the halogen atom or chalcogen atom X is placed at each face center.

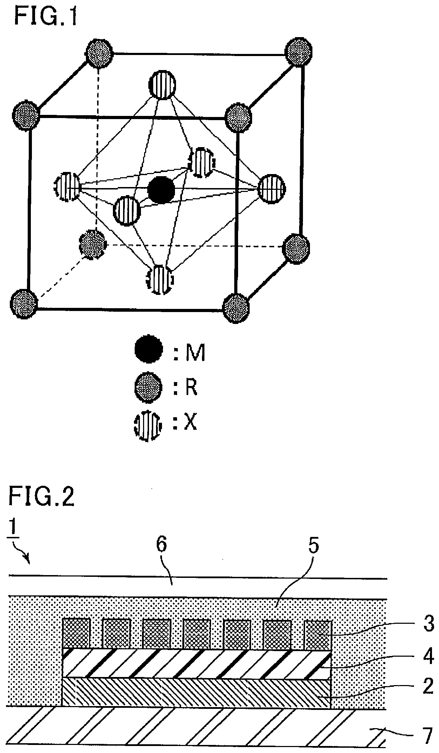

Fig. 1 is a schematic view illustrating an exemplary crystal structure of the organic-inorganic perovskite compound having a cubic structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, enhancing the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution. When the organic-inorganic perovskite compound is a crystalline semiconductor, the mobility of electrons in the organic-inorganic perovskite compound is enhanced, enhancing the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or more, the mobility of electrons in the organic-inorganic perovskite compound is enhanced, enhancing the photoelectric conversion efficiency of the solar cell. The lower limit of the degree of crystallinity is more preferably 50%, still more preferably 70%.

Examples of the method for increasing the degree of crystallinity of the organic-inorganic perovskite compound include heat annealing, irradiation with light having strong intensity, such as laser, and plasma irradiation.

The photoelectric conversion layer containing the organic-inorganic perovskite compound may further include an organic semiconductor or an inorganic semiconductor, in addition to the organic-inorganic perovskite compound, without impairing the effects of the present invention. In this context, the organic semiconductor or the inorganic semiconductor may play a role as an electron transport layer or a hole transport layer mentioned later.

Examples of the organic semiconductor include compounds having a thiophene skeleton, such as poly(3-alkylthiophene). Examples thereof also include conductive polymers having a poly-p-phenylenevinylene skeleton, a polyvinylcarbazole skeleton, a polyaniline skeleton, a polyacetylene skeleton or the like. Examples thereof further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂ and Cu₂S.

The photoelectric conversion layer including the organic-inorganic perovskite compound and the organic semiconductor or inorganic semiconductor may be a laminate where a thin film-shaped organic semiconductor or inorganic semiconductor part and a thin film-shaped organic-inorganic perovskite compound part are laminated, or may be a composite film where an organic semiconductor or inorganic semiconductor part and an organic-inorganic perovskite compound part are combined. The laminate is preferred from the viewpoint that the production process is simple. The composite film is preferred from the viewpoint that the charge separation efficiency of the organic semiconductor or the inorganic semiconductor can be enhanced.

The lower limit of the thickness of the thin film-shaped organic-inorganic perovskite compound part is preferably 5 nm, and the upper limit thereof is preferably 5,000 nm. When the thickness is 5 nm or greater, light can be sufficiently absorbed, enhancing the photoelectric conversion efficiency. When the thickness is 5,000 nm or smaller, presence of a region in which charge separation cannot be achieved can be avoided, leading to higher photoelectric conversion efficiency. The lower limit of the thickness is more preferably 10 nm, and the upper limit thereof is more preferably 1,000 nm. The lower limit of the thickness is still more preferably 20 nm, and the upper limit thereof is still more preferably 500 nm.

When the photoelectric conversion layer is a composite film where an organic semiconductor or inorganic semiconductor part and an organic-inorganic perovskite compound part are combined, the lower limit of the thickness of the composite film is preferably 30 nm, and the upper limit thereof is preferably 3,000 nm. When the thickness is 30 nm or greater, light can be sufficiently absorbed, enhancing the photoelectric conversion efficiency. When the thickness is 3,000 nm or smaller, charge easily arrives at the electrode, enhancing the photoelectric conversion efficiency. The lower limit of the thickness is more preferably 40 nm, and the upper limit thereof is more preferably 2,000 nm. The lower limit of the thickness is still more preferably 50 nm, and the upper limit thereof is still more preferably 1,000 nm.

In the solar cell of the present invention, an electron transport layer may be disposed between the cathode and the photoelectric conversion layer.

Examples of the material for the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin film-shaped electron transport layer and preferably includes a porous electron transport layer. Particularly, when the photoelectric conversion layer is a composite film where an organic semiconductor or inorganic semiconductor part and an organic-inorganic perovskite compound part are combined, the composite film is preferably formed on a porous electron transport layer because a more complicated composite film (more intricate structure) is obtained, enhancing the photoelectric conversion efficiency.

The lower limit of the thickness of the electron transport layer is preferably 1 nm, and the upper limit thereof is preferably 2,000 nm. When the thickness is 1 nm or greater, holes can be sufficiently blocked. When the thickness is 2,000 nm or smaller, the layer is less likely to be the resistance to the electron transport, enhancing the photoelectric conversion efficiency. The lower limit of the thickness of the electron transport layer is more preferably 3 nm, and the upper limit thereof is more preferably 1,000 nm. The lower limit of the thickness is still more preferably 5 nm, and the upper limit thereof is still more preferably 500 nm.

In the solar cell of the present invention, a hole transport layer may be disposed between the anode and the photoelectric conversion layer.

Examples of the material of the hole transport layer include, but are not particularly limited to, P-type conductive polymers, P-type low-molecular organic semiconductors, P-type metal oxides, P-type metal sulfides, and surfactants. Specific examples thereof include polystyrenesulfonic acid adducts of polyethylenedioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, copper compounds such as CuSCN and CuI, and carbon-containing materials such as carbon nanotube and graphene, which may be surface-modified.

The lower limit of the thickness of the hole transport layer is preferably 1 nm, and the upper limit thereof is preferably 2,000 nm. When the thickness is 1 nm or greater, electrons can be sufficiently blocked. When the thickness is 2,000 nm or smaller, the layer is less likely to be the resistance to the hole transport, enhancing the photoelectric conversion efficiency. The lower limit of the thickness is more preferably 3 nm, and the upper limit thereof is more preferably 1,000 nm. The lower limit of the thickness is still more preferably 5 nm, and the upper limit thereof is still more preferably 500 nm.

The solar cell of the present invention may further have a substrate or the like. Examples of the substrate include, but are not particularly limited to, transparent glass substrates such as soda lime glass and alkali-free glass substrates, ceramic substrates, and transparent plastic substrates. The substrate may have any refractive index. Yet, in cases where the substrate contacts the resin layer, the difference in refractive index between the substrate and the resin layer is preferably small. For example, soda lime glass typically has a refractive index of about 1.4 or greater but 1.6 or smaller. Transparent plastic substrates typically have a refractive index of about 1.52 or greater but 1.60 or smaller.

In the solar cell of the present invention, a resin layer is disposed on at least one of the cathode and the anode, and an inorganic layer is disposed on the resin layer.

Disposing a resin layer on at least one of the cathode and the anode can enhance the high-temperature, high-humidity durability of the solar cell. This is probably because the resin layer can reduce moisture penetration inside the solar cell. In this context, the resin layer preferably covers the entire laminate including the cathode, the photoelectric conversion layer, and the anode so as to close the end portions thereof. This can reliably prevent moisture penetration inside the solar cell.

The resin layer has a glass transition temperature of 70°C or higher but 200°C or lower, and a coefficient of linear expansion of 9.0 × 10⁻⁶K⁻¹ or greater but 1.5 × 10⁻⁴K⁻¹ or smaller. With the glass transition temperature and the coefficient of linear expansion of the resin layer within the above ranges, when the inorganic layer is disposed (e.g., by sputtering) on the resin layer, the formation of fine surface protrusions and recesses in the inorganic layer and the resin layer can be reduced even in a high-temperature, high-humidity atmosphere. In addition, peeling and cracking of the inorganic layer can be reduced even in a high-temperature, high-humidity atmosphere. As a result, the solar cell can have an enhanced high-temperature, high-humidity durability. The resin layer with the glass transition temperature and coefficient of linear expansion within the above ranges is less likely to peel from the photoelectric conversion layer especially when the photoelectric conversion layer contains an organic-inorganic perovskite compound. Moreover, with the glass transition temperature and the coefficient of linear expansion of the resin layer within the above ranges, the solar cell can have beautiful gloss on the surface as the formation of fine surface protrusions and recesses in the resin layer can be reduced. This can enhance the design of the solar cell.

The lower limit of the glass transition temperature of the resin layer is preferably 85°C, more preferably 100°C. The upper limit is preferably 190°C, more preferably 180°C.

The glass transition temperature can be measured using a dynamic viscoelasticity measuring apparatus (e.g., DVA-200 available from IT Measurement Co., Ltd.) under a tensile condition (25°C to 125°C, 20°C/min). When the resin constituting the resin layer is a thermosetting resin or a photocurable resin, the term "glass transition temperature" means the glass transition temperature after the thermosetting resin or the photocurable resin is cured.

The lower limit of the coefficient of linear expansion of the resin layer is preferably 6.0 × 10⁻⁵K⁻¹. The upper limit is preferably 1.0 × 10⁻⁴K⁻¹.

The coefficient of linear expansion can be measured using a linear expansion coefficient measuring apparatus (e.g., TMA/SS600, available from Seiko Instruments Inc.) under a tensile condition (-60°C to 300°C, 10°C/min).

The resin layer may contain any resin as long as the glass transition temperature and the coefficient of linear expansion of the resin layer can be adjusted within the above range. The resin may be a thermoplastic resin, a thermosetting resin, or a photocurable resin. Examples of the thermoplastic resin include butyl rubber, polyester, polyurethane, polyvinyl alcohol, polyvinyl acetate, polybutadiene, polyamide, polyimide, polyisobutylene, cycloolefin resin, and diallyl phthalate resin. Examples of the thermosetting resin include epoxy resin, acrylic resin, silicone resin, phenol resin, melamine resin, urea resin, and diallyl phthalate resin. Examples of the photocurable resin include epoxy resin, vinyl resin, and ene-thiol resin.

In order to adjust the glass transition temperature and the coefficient of linear expansion of the resin layer within the above ranges, the resin layer preferably contains a resin having an alicyclic skeleton and/or an aromatic skeleton.

The alicyclic skeleton is not limited. Examples thereof include norbornene, isobornene, adamantane, cyclohexane, dicyclopentadiene, dicyclohexane, and cyclopentane skeletons. The aromatic skeleton is not limited. Examples thereof include a phthalate skeleton. These skeletons may be used alone or in combination of two or more thereof. In particular, a norbornene skeleton, an isobornene skeleton, an adamantane skeleton, a cyclohexane skeleton, and a phthalate skeleton are preferred because the use of any of these resins reduces the difference in refractive index between the resin layer and the cathode and anode materials.

For adjustment of the glass transition temperature and the coefficient of linear expansion of the resin layer within the above ranges, the resin having an alicyclic skeleton and/or an aromatic skeleton preferably contains the alicyclic skeleton and/or the aromatic skeleton in an amount of 30% by weight or more.

The term "amount of an alicyclic skeleton and/or an aromatic skeleton", in cases where the resin having an alicyclic skeleton and/or an aromatic skeleton is a copolymer of a monomer having an alicyclic skeleton and/or an aromatic skeleton and a monomer having neither an alicyclic skeleton nor an aromatic skeleton, means the amount of a component derived from the monomer having an alicyclic skeleton and/or an aromatic skeleton in the copolymer. The copolymer may be a thermoplastic resin, or a thermosetting resin or photocurable resin that is cured by reaction with a curing agent, that is, a prepolymer.

The amount of the component derived from the monomer having an alicyclic skeleton and that of the component derived from the monomer having an aromatic skeleton in the copolymer can be calculated from the weight of raw material monomers added, or from the results of compositional analysis by GC-MS or the like, for example.

The resin having an alicyclic skeleton and/or an aromatic skeleton may be any resin having an alicyclic skeleton and/or an aromatic skeleton. The resin may be a thermoplastic resin, a thermosetting resin, or a photocurable resin. These resins having an alicyclic skeleton and/or an aromatic skeleton may be used alone or in combination of two or more thereof.

The resin having an alicyclic skeleton and/or an aromatic skeleton may be a resin obtained by forming a resin having a reactive functional group into a film followed by crosslinking reaction of the reactive functional group.

Examples of the resin having an alicyclic skeleton include thermoplastic resins such as norbornene resin (TOPAS 6017S-04, available from Polyplastics Co., Ltd.) and norbornene resin (TOPAS 9014S-04, available from Polyplastics Co., Ltd.); and thermosetting resins and photocurable resins such as adamantane acrylate (available from Mitsubishi Gas Chemical Company, Inc.), isobornyl acrylate (TS-147, available from Shin-Nakamura Chemical Co., Ltd.), and alicyclic epoxy resin (Celloxide 2021P, available from Daicel Corporation). Examples of the resin having an aromatic skeleton include thermosetting resins and photocurable resins such as diallyl phthalate resin (DAISO DAP, available from Daiso Co., Ltd.).

In the resin layer, the resin having an alicyclic skeleton and/or an aromatic skeleton may be used in combination with a resin having neither an alicyclic skeleton not an aromatic skeleton.

The resin constituting the resin layer may have any refractive index. In general, the refractive index thereof is smaller than that of the materials that contact the resin layer (e.g., the cathode or anode, a substrate). For example, the norbornene resin typically has a refractive index of about 1.3 or greater but 1.6 or smaller. Isobornyl acrylate typically has a refractive index of about 1.3 or greater but 1.6 or smaller.

For adjustment of the glass transition temperature and the coefficient of linear expansion of the resin layer within the above ranges, the resin layer preferably contains an inorganic filler. The resin layer more preferably contains an inorganic filler having a refractive index of 1.80 or greater but 2.50 or smaller, an average particle size of 2 nm or greater but 50 nm or smaller, and an average pore size of 5 Å or greater but 5,000 Å or smaller, in an amount of 20% by volume or more but 70% by volume or less.

The addition of an inorganic filler with the refractive index, average particle size, and average pore size adjusted within the above ranges to the resin layer in an amount in the specific range reduces the difference in refractive index between the resin layer and the materials that contact the resin layer (e.g., the cathode or anode, a substrate). As a result, sunlight efficiently reaches the inside of the solar cell (inside of the photoelectric conversion layer), which can enhance the photoelectric conversion efficiency of the solar cell. Moreover, the addition of an inorganic filler with the refractive index adjusted within the above range in the above amount to the resin layer makes it easy to adjust the glass transition temperature and the coefficient of linear expansion of the resin layer within the above ranges, and also reduces the degradation of the solar cell (degradation of the photoelectric conversion layer) because the inorganic filler adsorbs moisture penetrating inside the resin layer. This can enhance the high-temperature, high-humidity durability of the solar cell.

When the inorganic filler has a refractive index of 1.80 or greater, the addition of the inorganic filler sufficiently increases the refractive index of the resin layer, thus reducing the difference in refractive index between the resin layer and the materials that contact the resin layer (e.g., the cathode or anode, a substrate). When the inorganic filler has a refractive index of 2.50 or smaller, the addition of the inorganic filler is less likely to excessively increase the refractive index of the resin layer. The lower limit of the refractive index of the inorganic filler is 1.90, more preferably 2.0. The upper limit thereof is preferably 2.40, more preferably 2.1.

When the inorganic filler has an average particle size of 2 nm or greater, the glass transition temperature and the coefficient of linear expansion of the resin layer can be easily adjusted within the above ranges, and also the inorganic filler can sufficiently adsorb the moisture penetrating inside the resin layer of the solar cell, so that the high-temperature, high-humidity durability of the solar cell can be enhanced. When the inorganic filler has an average particle size of 50 nm or smaller, the inorganic filler can be uniformly dispersed into the resin layer without aggregation. The lower limit of the average particle size of the inorganic filler is preferably 3 nm. The upper limit thereof is preferably 20 nm.

The average particle size of the inorganic filler can be measured using a nanoparticle size analyzer (e.g., SALD-7500NANO, available from Shimadzu Corporation).

For sufficient adsorption of the moisture penetrating inside the resin layer, the inorganic filler is preferably porous. The inorganic filler with an average pore size of 5 Å or greater but 5,000 Å or smaller can sufficiently adsorb moisture. The lower limit of the average pore size of the inorganic filler is preferably 10 Å, more preferably 15 Å.

Scanning electron microscopy (SEM) can confirm that the inorganic filler is porous. The average pore size of the inorganic filler can be calculated by an accelerated surface area and porosimetry system (e.g., ASAP 2020, available from Micromeritics Japan).

From the standpoint of sufficiently adsorbing the moisture penetrating inside the resin layer, the lower limit of the specific surface area of the inorganic filler is preferably 100 g/m². The upper limit thereof is preferably 1,000 g/m². The lower limit is more preferably 200 g/m². The upper limit is more preferably 900 g/m².

The specific surface area of the inorganic filler can be calculated using an accelerated surface area and porosimetry system (e.g., ASAP 2020, available from Micromeritics Japan).

When the amount of the inorganic filler is 20% by volume or more, the addition of the inorganic filler sufficiently increases the refractive index of the resin layer, thus reducing the difference in refractive index between the resin layer and the materials that contact the resin layer (e.g., the cathode or anode, a substrate). In addition, the inorganic filler in such an amount makes it easy to adjust the glass transition temperature and the coefficient of linear expansion of the resin layer within the above ranges, and also can sufficiently adsorb the moisture penetrating inside the resin layer, thus enhancing the high-temperature, high-humidity durability of the solar cell. When the amount of the inorganic filler is 70% by volume or less, the addition of the inorganic filler is less likely to excessively increase the refractive index of the resin layer. The lower limit of the amount of the inorganic filler is preferably 25% by volume, more preferably 35% by volume. The upper limit thereof is preferably 60% by volume, more preferably 50% by volume.

The inorganic filler is not limited as long as it has a refractive index adjusted within the above range. Examples thereof include oxides, sulfides, sulfates, and silicates.

Examples of the oxides include silica, zeolite, glass, calcium oxide, barium oxide, magnesium oxide, zirconium oxide, strontium oxide, and barium titanate.

Examples of the sulfides include zinc sulfide and magnesium sulfide.

Examples of the sulfates include lithium sulfate, sodium sulfate, potassium sulfate, magnesium sulfate, cobalt sulfate, gallium sulfate, and titanium sulfate.

Examples of the silicates include zirconium silicate and bismuth silicate. In particular, the inorganic filler preferably contains at least one selected from the group consisting of an oxide and a sulfate because it is preferred that the inorganic filler is a compound having a moisture adsorption function and remaining solid even after adsorbing moisture.

The surface of the inorganic filler is preferably subjected to hydrophobization treatment, and also preferably not subjected to hydrophilization treatment. When the surface of the inorganic filler is subjected to hydrophobization treatment and/or not subjected to hydrophilization treatment, the dispersibility of the hygroscopic inorganic filler into resin is enhanced, which further enhances the high-temperature, high-humidity durability of the solar cell. The surface treatment agent for the hydrophobic treatment of the surface of the inorganic filler may be, for example, a silane coupling agent. The surface treatment for hydrophilization treatment may be, for example, fluorine gas treatment.

The lower limit of the thickness of the resin layer is preferably 100 nm. The upper limit thereof is preferably 100,000 nm. When the thickness is 100 nm or greater, the resin layer can sufficiently entirely cover at least one of the cathode and the anode. When the thickness is 100,000 nm or smaller, water vapor entering from the side face of the resin layer can be sufficiently blocked. The lower limit of the thickness is more preferably 500 nm. The upper limit thereof is more preferably 50,000 nm. The lower limit is still more preferably 1,000 nm. The upper limit is still more preferably 2,000 nm.

In the solar cell of the present invention, the inorganic layer is disposed on the resin layer. This can enhance the high-temperature, high-humidity durability of the solar cell because the inorganic layer has a water vapor barrier property and can reduce moisture penetration inside the resin layer.

In the solar cell of the present invention, the inorganic layer may also be disposed between at least one of the cathode and the anode and the resin layer. Also in this case, the high-temperature, high-humidity durability of the solar cell can be further enhanced because the inorganic layer has a water vapor barrier property and can reduce moisture penetration inside the resin layer.

The inorganic layer preferably contains a metal oxide, a metal nitride, or a metal oxynitride. The metal oxide, metal nitride, and metal oxynitride are not limited as long as they have a water vapor barrier property. Examples thereof include oxides, nitrides and oxynitrides of Si, Al, Zn, Sn, In, Ti, Mg, Zr, Ni, Ta, W, Cu and alloys containing two or more thereof. In particular, oxides, nitrides, and oxynitrides of metal elements containing both Zn and Sn are preferred for the purpose of imparting a water vapor barrier property and flexibility to the inorganic layer.

The metal oxide, metal nitride, or metal oxynitride is preferably a metal oxide represented by the formula ZnₐSn_{b}O_{c}. The use of the metal oxide represented by the formula ZnₐSn_{b}O_{c} in the inorganic layer imparts moderate flexibility to the inorganic layer because the metal oxide contains a tin (Sn) atom, so that stress is decreased even when the thickness of the inorganic layer is increased. Therefore, peeling of the inorganic layer, electrode, semiconductor layer, and the like can be reduced. This can increase the water vapor barrier property of the inorganic layer and further enhance the high-temperature, high-humidity durability of the solar cell.

In the metal oxide represented by the formula ZnₐSn_{b}O_{c}, the ratio Xs (% by weight) of Sn to the total sum of Zn and Sn preferably satisfies 70 > Xs > 0.

The element ratios of zinc (Zn), tin (Sn), and oxygen (O) contained in the metal oxide represented by the formula ZnₐSn_{b}O_{c} in the inorganic layer can be measured using an X-ray photoemission spectroscopy (XPS) surface analyzer (e.g., ESCALAB-200R available from VG Scientific).

When the inorganic layer contains the metal oxide represented by the formula ZnₐSn_{b}O_{c}, the inorganic layer preferably further contains silicon (Si) and/or aluminum (Al).

The addition of silicon (Si) and/or aluminum (Al) to the inorganic layer increase the transparency of the inorganic layer, which can enhance the photoelectric conversion efficiency of the solar cell.

The lower limit of the thickness of the inorganic layer is preferably 30 nm, and the upper limit thereof is preferably 3,000 nm. When the thickness is 30 nm or greater, the inorganic layer can have a sufficient water vapor barrier property, enhancing the high-temperature, high-humidity durability of the solar cell. When the thickness is 3,000 nm or smaller, only small stress is generated even when the thickness of the inorganic layer is increased. Therefore, peeling of the inorganic layer, electrode, semiconductor layer, and the like can be reduced. The lower limit of the thickness is more preferably 50 nm, and the upper limit thereof is more preferably 1,000 nm. The lower limit of the thickness is still more preferably 100 nm, and the upper limit thereof is still more preferably 500 nm.

The thickness of the inorganic layer can be measured using an optical interference-type film thickness measurement apparatus (e.g., FE-3000 available from Otsuka Electronics Co., Ltd.).

Fig. 2 is a cross-sectional view schematically illustrating an exemplary solar cell of the present invention.

A solar cell 1 shown in Fig. 2 has a cathode 2, an anode 3, and a photoelectric conversion layer 4 disposed between the cathode 2 and the anode 3 on a substrate 7. A resin layer 5 is disposed on the anode 3, and an inorganic layer 6 is disposed on the resin layer 5. The end portions of the resin layer 5 are closed by intimate contact with the substrate 7. In the solar cell 1 shown in Fig. 2, the anode 3 is a patterned electrode.

The solar cell of the present invention may be produced by any method. Examples of the method include a method involving forming, on the substrate, the cathode, the photoelectric conversion layer, and the anode in the stated order, followed by encapsulation by disposing the resin layer on the anode and disposing the inorganic layer on the resin layer; and a method involving forming, on the substrate, the anode, the photoelectric conversion layer, and the cathode in the stated order, followed by encapsulation by disposing the resin layer on the cathode and disposing the inorganic layer on the resin layer.

Examples of the method for forming the photoelectric conversion layer include, but are not particularly limited to, a vapor deposition method, a sputtering method, a chemical vapor deposition (CVD) method, an electrochemical deposition method, and a printing method. Among them, a printing method enables simple formation of a large-area solar cell that can exhibit high photoelectric conversion efficiency. Examples of the printing method include a spin coating method and a casting method. Examples of the method using the printing method include a roll-to-roll method.

The resin layer may be disposed on the cathode or the anode by any method. Examples of the method include a method involving sealing the cathode or the anode with a sheet-like resin layer, a method involving applying a resin solution of a resin to constitute the resin layer in an organic solvent onto the cathode or the anode, a method involving applying a liquid monomer to form the resin layer onto the cathode or the anode and then polymerizing the liquid monomer with heat, UV, or the like, and a method involving melting the resin layer with heat, followed by cooling.

The method of disposing the inorganic layer on the resin layer is preferably a vacuum deposition method, a sputtering method, a chemical vapor deposition (CVD) method, or an ion plating method. Among them, a sputtering method is preferred for forming a dense layer. The sputtering method is more preferably a DC magnetron sputtering method. In the sputtering method, the inorganic layer can be formed by depositing raw materials including a metal target and oxygen gas or nitrogen gas on the resin layer for film formation.

### - Advantageous Effects of Invention

The present invention provides a solar cell excellent in high-temperature, high-humidity durability.

### BRIEF DESCRIPTION OF DRAWINGS

Fig. 1 is a schematic view illustrating an exemplary crystalline structure of an organic-inorganic perovskite compound.
Fig. 2 is a schematic cross-sectional view illustrating an exemplary solar cell of the present invention.

### DESCRIPTION OF EMBODIMENTS

Hereinafter, the present invention will be described in more detail with reference to examples. However, the present invention is not intended to be limited by these examples.

### (Example 1)

### (1) Production of laminate (cathode/electron-transport layer/photoelectric conversion layer/anode laminate)

A FTO film having a thickness of 1,000 nm was formed as a cathode on a glass substrate, ultrasonically washed with pure water, acetone, and methanol each for ten minutes in the stated order, and then dried.

A solution of titanium isopropoxide in ethanol adjusted to 2% was applied onto the surface of the FTO film by the spin coating method and then fired at 400°C for 10 minutes to form a thin film-shaped electron transport layer having a thickness of 20 nm. A titanium oxide paste containing polyisobutyl methacrylate as an organic binder and titanium oxide (mixture of powders having average particle sizes of 10 nm and 30 nm) was further applied onto the thin film-shaped electron transport layer by the spin coating method and then fired at 500°C for 10 minutes to form a porous electron transport layer having a thickness of 500 nm.

Subsequently, CH₃NH₃I and PbCl₂ were dissolved at a mole ratio of 3:1 into N,N-dimethylformamide (DMF) as a solvent to prepare a solution for organic-inorganic perovskite compound formation having a total concentration of CH₃NH₃I and PbCl₂ of 20% by weight. This solution was applied onto the electron-transport layer by a spin coating method. Further, 68 mM of poly-TPD (having a triphenylamine skeleton), 55 mM of tert-butylpyridine, and 9 mM of lithium bis(trifluoromethanesufonyl)imide salt were dissolved into 25 µL of chlorobenzene to prepare a solution. This solution was applied to a thickness of 300 nm by the spin coating method to form a photoelectric conversion layer.

A gold film having a thickness of 100 nm was formed as an anode on the photoelectric conversion layer by vacuum deposition method, whereby a laminate (cathode/electron-transport layer/photoelectric conversion layer/anode laminate) was obtained.

### (2) Formation of resin layer

A 10% solution in cyclohexane of TOPAS 6017S-04 (norbornene resin, available from Polyplastics Co., Ltd.), which is a cyclic olefin polymer containing 82% by weight of an alicyclic skeleton, as a resin to constitute a resin layer was applied onto the anode of the obtained laminate (cathode/electron-transport layer/photoelectric conversion layer/anode laminate) with a doctor blade. The organic solvent was dried to form a resin layer having a thickness of 5 µm.

### (3) Formation of inorganic layer

The sample with the formed resin layer was set in a substrate holder of a sputtering device. A ZnSn alloy (Zn:Sn = 95:5 (% by weight)) target was mounted on the cathode A of the sputtering device, and an Si target was mounted on the cathode B. The film forming chamber of the sputtering device was evacuated using a vacuum pump to reduce pressure to 5.0 × 10⁻⁴ Pa. Then, sputtering was performed under Film formation condition A to form a 100 nm ZnSnO(Si) thin film as an inorganic layer on the resin layer. Thus, a solar cell was obtained.

### (Film formation condition A)

Argon gas flow rate: 50 sccm, oxygen gas flow rate: 50 sccm
Power output: cathode A = 500 W, cathode B = 1500 W

### (4) Measurement of glass transition temperature and coefficient of linear expansion of resin layer

To a polyethylene terephthalate (PET) film subjected to a mold release treatment was applied, with a doctor blade, a 10% solution in cyclohexane of TOPAS 6017S-04 (norbornene resin, available from Polyplastics Co., Ltd.), which is a cyclic olefin polymer containing 82% by weight of an alicyclic skeleton, as a resin to constitute a resin layer. The organic solvent was dried to form a resin layer having a thickness of 500 µm. The obtained resin layer was released from the PET film and used as a sample.

The glass transition temperature of the resin layer was measured using a dynamic viscoelasticity measuring apparatus (DVA-200, available from IT Measurement Co., Ltd.) under a tensile condition (25°C to 125°C, 20°C/min). The coefficient of linear expansion of the resin layer was also measured using a linear expansion coefficient measuring apparatus (TMA/SS600, available from Seiko Instruments Inc.) under a tensile condition (-60°C to 300°C, 10°C/min).

### (Examples 2 to 10, Comparative Examples 1 to 4)

A solar cell was obtained in the same manner as in Example 1 except that the type of the photoelectric conversion layer, the resin to constitute the resin layer, the glass transition temperature and the coefficient of linear expansion of the resin layer, and the type of the inorganic layer were changed as shown in Table 1.

### (Example 2)

A solar cell was obtained in the same manner as in Example 1 except for the following: In "(2) Formation of resin layer", a 10% solution in cyclohexane of TOPAS 6015S-04 (norbornene resin, available from Polyplastics Co., Ltd.), which is a cyclic olefin polymer containing 80% by weight of an alicyclic skeleton, was applied onto the anode of the obtained laminate (cathode/electron-transport layer/photoelectric conversion layer/anode laminate) with a doctor blade, and the organic solvent was dried to form a resin layer having a thickness of 5 µm.

### (Example 3)

A solar cell was obtained in the same manner as in Example 1 except for the following: In "(2) Formation of resin layer", 4 mol% of a peroxide (PERCUMYL D, available from NOF Corporation) as a curing agent was added to a 10% solution in cyclohexane of DAISO DAP (diallyl phthalate resin, available from Daiso Co., Ltd.), which is a diallyl phthalate polymer containing 50% by weight of an aromatic skeleton. The solution was applied onto the anode of the obtained laminate (cathode/electron-transport layer/photoelectric conversion layer/anode laminate) with a doctor blade, and cured by heating at 100°C for 10 minutes to form a resin layer having a thickness of 5 µm.

### (Example 4)

A solar cell was obtained in the same manner as in Example 1 except for the following: In "(2) Formation of resin layer", a solution was prepared containing Celloxide 2021P (epoxy resin, available from Daicel Corporation), which is an epoxy monomer having an alicyclic skeleton, as a main component and a thermal cationic catalyst (SI-100L, available from Sanshin Chemical Industry Co., Ltd.) as a curing agent in an amount of 1% by weight relative to the main component. The solution was applied onto the anode of the obtained laminate (cathode/electron-transport layer/photoelectric conversion layer/anode laminate) with a doctor blade, and cured at 150°C for two hours to form a resin layer having a thickness of 5 µm.

### (Example 5)

A solar cell was obtained in the same manner as in Example 1 except for the following: In "(2) Formation of resin layer", 4 mol% of a peroxide (PERCUMYL D, available from NOF Corporation) as a curing agent was added to a 10% solution in cyclohexane of DAISO ISO DAP (diallyl phthalate resin, available from Daiso Co., Ltd.), which is a diallyl phthalate polymer containing 80% by weight of an aromatic skeleton. The solution was applied onto the anode of the obtained laminate (cathode/electron-transport layer/photoelectric conversion layer/anode laminate) with a doctor blade, and cured by heating at 100°C for 10 minutes to form a resin layer having a thickness of 5 µm.

### (Example 6)

A solar cell was obtained in the same manner as in Example 1 except for the following: In "(2) Formation of resin layer", 4 mol% of a peroxide (PERCUMYL D, available from NOF Corporation) as a curing agent was added to a 10% solution in cyclohexane of TS-147 (isobornyl acrylate resin, available from Shin-Nakamura Chemical Co., Ltd., containing 40% by weight of an alicyclic skeleton), which is a thermosetting resin, as a resin to constitute a resin layer. The solution was applied onto the anode of the obtained laminate (cathode/electron-transport layer/photoelectric conversion layer/anode laminate) with a doctor blade, and cured by heating at 100°C for 10 minutes to form a resin layer having a thickness of 5 µm.

### (Example 7)

A solar cell was obtained in the same manner as in Example 1 except for the following: In "(2) Formation of resin layer", a 10% solution in cyclohexane of TOPAS 8007S-04 (norbornene resin, available from Polyplastics Co., Ltd., containing 76% by weight of an alicyclic skeleton), which is a cyclic olefin polymer containing 76% by weight of an alicyclic skeleton, was applied onto the anode of the obtained laminate (cathode/electron-transport layer/photoelectric conversion layer/anode laminate) with a doctor blade. The organic solvent was dried to form a resin layer having a thickness of 5 µm.

### (Example 8)

A solar cell was obtained in the same manner as in Example 1 except for the following: In "(2) Formation of resin layer", 4 mol% of a peroxide (PERCUMYL D, available from NOF Corporation) as a curing agent was added to a 10% solution in cyclohexane of a 8:2 (w/w) mixture (containing 70% by weight of an alicyclic skeleton and/or an aromatic skeleton) of DAISO DAP (diallyl phthalate resin, available from Daiso Co., Ltd.), which is a diallyl phthalate polymer containing 50% by weight of an aromatic skeleton, and cyclohexyl acrylate (acrylic resin, available from Wako Pure Chemical Industries, Ltd.), which is a thermosetting resin. The solution was applied onto the anode of the obtained laminate (cathode/electron-transport layer/photoelectric conversion layer/anode laminate) with a doctor blade, and the organic solvent was dried to form a resin layer having a thickness of 5 µm.

### (Example 9)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of TS-147 (isobornyl acrylate resin, available from Shin-Nakamura Chemical Co., Ltd., containing 40% by weight of an alicyclic skeleton), which is a thermosetting resin, as a resin to constitute a resin layer, and also containing SZR-K (zirconium oxide particles, average particle size: 4 nm, refractive index: 2.1, available from Nippon Shokubai Co., Ltd.) as an inorganic filler dispersed therein. The solution was applied onto the anode of the obtained laminate (cathode/electron-transport layer/photoelectric conversion layer/anode laminate) with a doctor blade, and cured by heating at 100°C for 10 minutes to form a resin layer having a thickness of 5 µm.

### (Example 10)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of TS-147 (isobornyl acrylate resin, available from Shin-Nakamura Chemical Co., Ltd., containing 40% by weight of an alicyclic skeleton), which is a thermosetting resin, as a resin to constitute a resin layer, and also containing TECHPOW-TIO₂ (titanium oxide particles, average particle size: 15 nm, refractive index: 2.79, available from Tecman Co., Ltd.) as an inorganic filler dispersed therein. The solution was applied onto the anode of the obtained laminate (cathode/electron-transport layer/photoelectric conversion layer/anode laminate) with a doctor blade, and cured by heating at 100°C for 10 minutes to form a resin layer having a thickness of 5 µm.

### (Comparative Example 1)

A solar cell was obtained in the same manner as in Example 1 except for the following: In the "(2) Formation of resin layer", a 10% solution in cyclohexane of TOPAS 9506F-04 (norbornene resin, available from Polyplastics Co., Ltd.), which is a cyclic olefin polymer containing 62% by weight of an alicyclic skeleton, was applied onto the anode of the obtained laminate (cathode/electron-transport layer/photoelectric conversion layer/anode laminate) with a doctor blade, and the organic solvent was dried to form a resin layer having a thickness of 5 µm.

### (Comparative Example 2)

A solar cell was obtained in the same manner as in Example 1 except for the following: In "(2) Formation of resin layer", a 10% solution in cyclohexane of OPPANOL-B50 (polyisobutylene resin, available from BASF) was applied onto the anode of the obtained laminate (cathode/electron-transport layer/photoelectric conversion layer/anode laminate) with a doctor blade, and the organic solvent was dried to form a resin layer having a thickness of 5 µm.

### (Comparative Example 3)

A solar cell was obtained in the same manner as in Example 1 except for the following: In "(2) Formation of resin layer", a solution was prepared containing Celloxide 8000 (epoxy resin, available from Daicel Corporation), which is an epoxy monomer containing an alicyclic skeleton, as a main component and a thermal cationic catalyst (SI-100L, available from Sanshin Chemical Industry Co., Ltd.) as a curing agent in an amount of 1% by weight relative to the main component. The solution was applied onto the anode of the obtained laminate doctor blade (cathode/electron-transport layer/photoelectric conversion layer/anode laminate) with a doctor blade, and cured at 150°C for two hours to form a resin layer having a thickness of 5 µm.

### (Comparative Example 4)

A solar cell was obtained in the same manner as in Example 1 except for the following: In (2) Formation of resin layer", 4 mol% of a peroxide (PERCUMYL D, available from NOF Corporation) as a curing agent was added to a 10% solution in cyclohexane of a 5:5 (w/w) mixture (containing 20% by weight of an aromatic skeleton) of DAISO DAP (diallyl phthalate resin, available from Daiso Co., Ltd.), which is a diallyl phthalate polymer containing 50% by weight of an aromatic skeleton, and lauryl acrylate (acrylic resin, available from Wako Pure Chemical Industries, Ltd.), which is a thermosetting resin. The solution was applied onto the anode of the obtained laminate (cathode/electron-transport layer/photoelectric conversion layer/anode laminate) with a doctor blade, and the organic solvent was dried to form a resin layer having a thickness of 5 µm.

### <Evaluation 1>

The solar cells obtained in Examples 1 to 10 and Comparative Examples 1 to 4 were subjected to the following evaluations. Table 2 shows the results.

### (1) Presence or absence of fine surface protrusions and recesses in inorganic layer and resin layer

After a high-temperature, high-humidity durability test, the surface of the inorganic layer was visually checked for the presence or absence of fine surface protrusions and recesses.
○ (Good): No fine surface protrusions and recesses were found on the surface.
× (Poor): Fine surface protrusions and recesses were found on the surface.

### (2) High-temperature, high-humidity durability

A high-temperature, high-humidity durability test was performed by leaving the solar cell under the conditions of a humidity of 85% and a temperature of 85°C for 24 hours. In the solar cell immediately after the formation of the inorganic layer and the solar cell after the high-temperature, high-humidity durability test, a power source (available from Keithley Instruments Inc., Model 236) was connected between the electrodes. The photoelectric conversion efficiency was measured using a solar simulator (available from Yamashita Denso Corp.) having an intensity of 100 mW/cm², and the value of photoelectric conversion efficiency after the high-temperature, high-humidity durability test/photoelectric conversion efficiency immediately after the formation of the inorganic layer was calculated.
○○ (Very good): The photoelectric conversion efficiency after high-temperature, high-humidity durability test/photoelectric conversion efficiency immediately after the formation of the inorganic layer (immediately after encapsulation) was 0.9 or greater.
○ (Good): The photoelectric conversion efficiency after high-temperature, high-humidity durability test/photoelectric conversion efficiency immediately after the formation of the inorganic layer (immediately after encapsulation) was 0.8 or greater but smaller than 0.9.
Δ (Average): The photoelectric conversion efficiency after high-temperature, high-humidity durability test/photoelectric conversion efficiency immediately after the formation of the inorganic layer (immediately after encapsulation) was 0.7 or greater but smaller than 0.8.
× (Poor): The photoelectric conversion efficiency after high-temperature, high-humidity durability test/photoelectric conversion efficiency immediately after the formation of the inorganic layer (immediately after encapsulation) was smaller than 0.7.

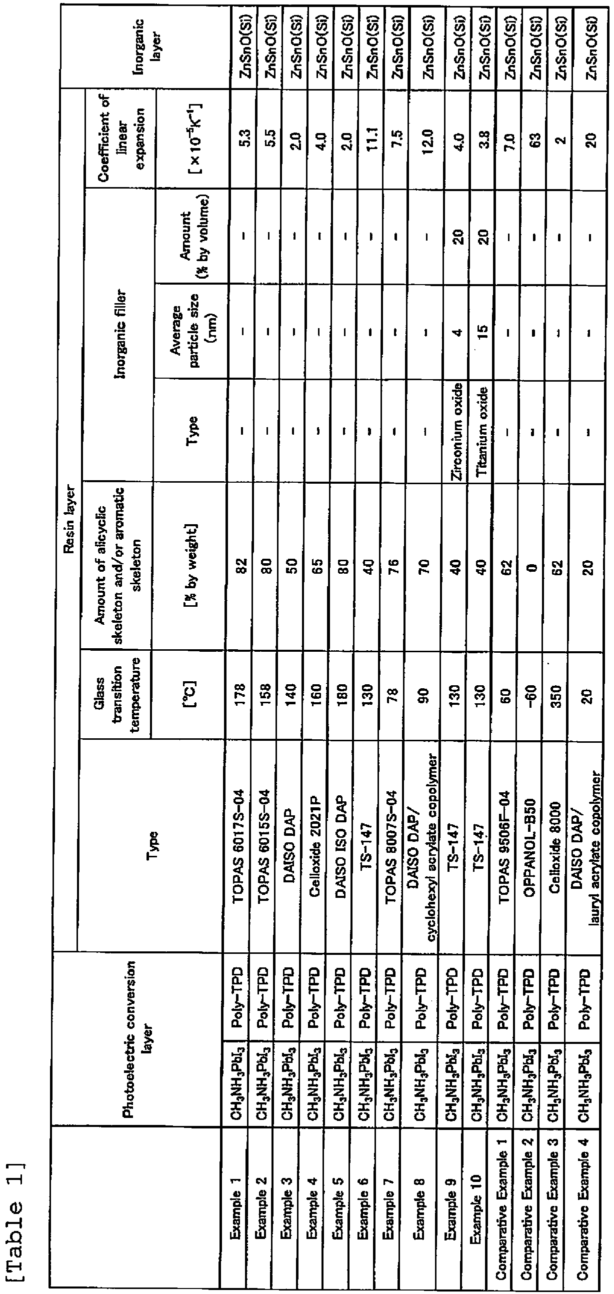

**[Table 2]**

| | Evaluation | |
|---|---|---|
| | Fine surface protrusions and recesses | High-temperature, high-humidity durability |
| Example 1 | ○ | ○○ |
| Example 2 | ○ | ○○ |
| Example 3 | ○ | ○○ |
| Example 4 | ○ | ○○ |
| Example 5 | ○ | ○○ |
| Example 6 | ○ | ○ |
| Example 7 | ○ | Δ |
| Example 8 | ○ | ○ |
| Example 9 | ○ | ○○ |
| Example 10 | ○ | ○○ |
| Comparative Example 1 | × | × |
| Comparative Example 2 | × | × |
| Comparative Example 3 | × | × |
| Comparative Example 4 | × | × |

### (Example 11)

### (1) Production of laminate (cathode/electron-transport layer/photoelectric conversion layer/anode laminate)

A FTO film having a thickness of 1,000 nm was formed as a cathode on a glass substrate, ultrasonically washed with pure water, acetone, and methanol each for ten minutes in the stated order, and then dried.

A solution of titanium isopropoxide in ethanol adjusted to 2% was applied onto the surface of the FTO film by the spin coating method and then fired at 400°C for 10 minutes to form a thin film-shaped electron transport layer having a thickness of 20 nm. A titanium oxide paste containing polyisobutyl methacrylate as an organic binder and titanium oxide (mixture of powders having average particle sizes of 10 nm and 30 nm) was further applied onto the thin film-shaped electron transport layer by the spin coating method and then fired at 500°C for 10 minutes to form a porous electron transport layer having a thickness of 500 nm.

Subsequently, CH₃NH₃I and PbCl₂ were dissolved at a mole ratio of 3:1 into N,N-dimethylformamide (DMF) as a solvent to prepare a solution for organic-inorganic perovskite compound formation having a total concentration of CH₃NH₃I and PbCl₂ of 20% by weight. This solution was applied onto the electron-transport layer by the spin coating method. Furthermore, an 1% by weight solution of poly(4-butylphenyl-diphenyl-amine) (available from 1-Material Inc.) in chlorobenzene was applied onto the organic-inorganic perovskite compound part by the spin coating method to a thickness of 50 nm, whereby a photoelectric conversion layer was formed.

An ITO film (refractive index: 1.9) having a thickness of 100 nm as an anode was formed onto the photoelectric conversion layer by the vacuum deposition method, whereby a laminate (cathode/electron-transport layer/photoelectric conversion layer/anode laminate) was obtained.

### (2) Formation of resin layer

As a curing agent, 4 mol% of a peroxide (PERCUMYL D, available from NOF Corporation) was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing SZR-K (zirconium oxide particles, average particle size: 4 nm, refractive index: 2.1, available from Nippon Shokubai Co., Ltd.) as an inorganic filler dispersed therein. The solution was applied onto the anode of the obtained laminate (cathode/electron-transport layer/photoelectric conversion layer/anode laminate) with a doctor blade, and the organic solvent was dried to form a resin layer having a thickness of 5 µm and containing 25% by volume of the inorganic filler. The average pore size of all the inorganic filler used in the example was in the range of 5 Å or greater and 5,000 Å or smaller.

### (3) Formation of inorganic layer

The sample with the formed resin layer was set in a substrate holder of a sputtering device. A ZnSn alloy (Zn:Sn = 95:5 (% by weight)) target was mounted on the cathode A of the sputtering device, and an Si target was mounted on the cathode B. The film forming chamber of the sputtering device was evacuated using a vacuum pump to reduce pressure to 5.0 × 10⁻⁴ Pa. Then, sputtering was performed under Film formation condition A to form a 100 nm ZnSnO(Si) thin film as an inorganic layer on the resin layer. Thus, a solar cell was obtained.

### (Film formation condition A)

Argon gas flow rate: 50 sccm, oxygen gas flow rate: 50 sccm
Power output: cathode A = 500 W, cathode B = 1,500 W

### (4) Measurement of glass transition temperature and coefficient of linear expansion of resin layer

As a curing agent, 4 mol% of a peroxide (PERCUMYL D, available from NOF Corporation) was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing SZR-K (zirconium oxide particles, average particle size: 4 nm, refractive index: 2.1, available from Nippon Shokubai Co., Ltd.) as an inorganic filler dispersed therein. The solution was applied with a doctor blade to a polyethylene terephthalate (PET) film subjected to a mold release treatment. The organic solvent was dried to form a resin layer having a thickness of 500 µm and containing 25% by volume of the inorganic filler. The obtained resin layer was released from the PET film and used as a sample.

The glass transition temperature of the resin layer was measured using a dynamic viscoelasticity measuring apparatus (DVA-200, available from IT Measurement Co., Ltd.) under a tensile condition (25°C to 125°C, 20°C/min). The coefficient of linear expansion of the resin layer was also measured using a linear expansion coefficient measuring apparatus (TMA/SS600, available from Seiko Instruments Inc.) under a tensile condition (-60°C to 300°C, 10°C/min).

### (Examples 12 to 19)

A solar cell was obtained in the same manner as in Example 1 except that the type of the photoelectric conversion layer, the type of the resin to constitute the resin layer, the type and amount of the inorganic filler contained in the resin layer, and the type of the inorganic layer were changed as shown in Table 3.

### (Example 12)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing TECHPOW-TIO₂ (titanium oxide particles, average particle size: 15 nm, refractive index: 2.79, available from Tecman Co., Ltd.) as an inorganic filler dispersed therein. The solution was applied onto the anode of the obtained laminate (cathode/electron-transport layer/photoelectric conversion layer/anode doctor blade laminate) with a doctor blade, and the organic solvent was dried to form a resin layer having a thickness of 5 µm and containing 25% by volume of the inorganic filler.

### (Example 13)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing SZR-K (zirconium oxide particles, average particle size: 4 nm, refractive index: 2.1, available from Nippon Shokubai Co., Ltd.) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 70% by volume of the inorganic filler.

### (Example 14)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing TECHPOW-ZrO₂ (zirconium oxide particles, average particle size: 20 nm, refractive index: 2.1, available from Tecman Co., Ltd.) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 20% by volume of the inorganic filler.

### (Example 15)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing magnesium fluoride particles (average particle size: 40 nm, refractive index: 1.3) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 20% by volume of the inorganic filler.

### (Example 16)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing antimony sulfide particles (average particle size: 40 nm, refractive index: 4.06) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 20% by volume of the inorganic filler.

### (Example 17)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing SZR-K (zirconium oxide particles, average particle size: 4 nm, refractive index: 2.1, available from Nippon Shokubai Co., Ltd.) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 1% by volume of the inorganic filler.

### (Example 18)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing SZR-K (zirconium oxide particles, average particle size: 4 nm, refractive index: 2.1, available from Nippon Shokubai Co., Ltd.) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 80% by volume of the inorganic filler.

### (Example 19)

A solar cell was obtained in the same manner as in Example 1 except for the following: In "(2) Formation of resin layer", 4 mol% of a peroxide (PERCUMYL D, available from NOF Corporation) as a curing agent was added to a solution containing, in cyclohexane, 10% of DAISO DAP (diallyl phthalate resin, available from Daiso Co., Ltd.), which is a diallyl phthalate polymer containing 50% by weight of an aromatic skeleton, as a resin to constitute a resin layer, and also containing TA-200 (titanium oxide particles, average particle size: 610 nm, refractive index: 2.79, available from Fuji Titanium Industry Co., Ltd.) as an inorganic filler dispersed therein. The solution was applied onto the anode of the obtained laminate (cathode/electron-transport layer/photoelectric conversion layer/anode laminate) with a doctor blade. The organic solvent was dried to form a resin layer having a thickness of 5 µm and containing 20% by volume of the inorganic filler.

### <Evaluation 2>

The solar cells obtained in Examples 11 to 19 were subjected to the following evaluations. Table 4 shows the results.

### (1) Photoelectric conversion efficiency

A power source (236 model, available from Keithley Instruments, Inc.) was connected between the electrodes of the solar cell. The photoelectric conversion efficiency was measured using a solar simulator (available from Yamashita Denso Corp.) having an intensity of 100 mW/cm², and the obtained value was taken as the initial conversion efficiency. The obtained value was normalized relative to the initial conversion efficiency of the solar cell obtained in Example 3.
○ (Good): The normalized photoelectric conversion efficiency was 1.2 or greater.
Δ (Average): The normalized photoelectric conversion efficiency was smaller than 1.2.

### (2) Presence or absence of fine surface protrusions and recesses in inorganic layer and resin layer

After a high-temperature, high-humidity durability test, the surface of the inorganic layer was visually checked for the presence or absence of fine surface protrusions and recesses.
○ (Good): No fine surface protrusions and recesses were found on the surface.
× (Poor): Fine surface protrusions and recesses were found on the surface.

### (3) High-temperature, high-humidity durability

A high-temperature, high-humidity durability test was performed by leaving the solar cell under the conditions of a humidity of 85% and a temperature of 85°C for 24 hours. A power source (available from Keithley Instruments Inc., Model 236) was connected between the electrodes of the solar cell after the high-temperature, high-humidity durability test. The photoelectric conversion efficiency was measured using a solar simulator (available from Yamashita Denso Corp.) having an intensity of 100 mW/cm². The obtained value was normalized relative to the photoelectric conversion efficiency of the solar cell obtained in Example 3 after the high-temperature, high-humidity durability test.
○○ (Very good): The normalized photoelectric conversion efficiency after the high-temperature, high-humidity durability test was 1.1 or greater.
○ (Good): The normalized photoelectric conversion efficiency after high-temperature, high-humidity durability test was 1.05 or greater but smaller than 1.1.
Δ (Average): The normalized photoelectric conversion efficiency after high-temperature, high-humidity durability test was smaller than 1.05.

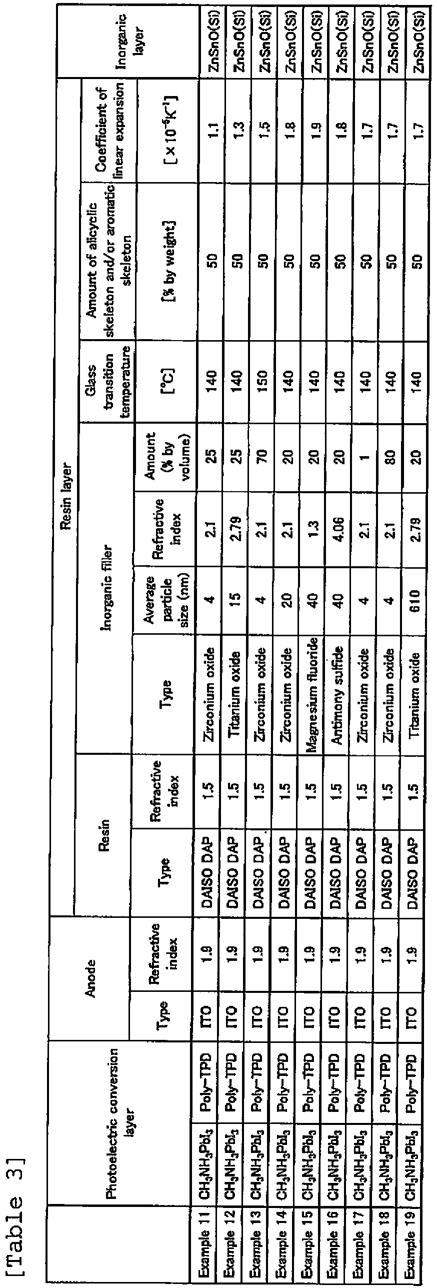

**[Table 4]**

| | Evaluation | | |
|---|---|---|---|
| | Photoelectric conversion efficiency | Fine surface protrusions and recesses | High-temperature, high-humidity durability |
| Example 11 | ○ | ○ | ○○ |
| Example 12 | ○ | ○ | ○○ |
| Example 13 | ○ | ○ | ○ |
| Example 14 | ○ | ○ | ○ |
| Example 15 | Δ | ○ | Δ |
| Example 16 | Δ | ○ | Δ |
| Example 17 | Δ | ○ | Δ |
| Example 18 | Δ | ○ | Δ |
| Example 19 | Δ | ○ | Δ |

### INDUSTRIAL APPLICABILITY

The present invention provides a solar cell excellent in high-temperature, high-humidity durability. ×

### REFERENCE SIGNS LIST

- 1: solar cell
- 2: cathode
- 3: anode (patterned electrode)
- 4: photoelectric conversion layer
- 5: resin layer
- 6: inorganic layer
- 7: substrate

## Claims

1. A solar cell comprising:
a cathode;
an anode; and
a photoelectric conversion layer disposed between the cathode and the anode,
the photoelectric conversion layer containing an organic-inorganic perovskite compound represented by the formula R-M-X₃ where R is an organic molecule, M is a metal atom, and X is a halogen atom or a chalcogen atom,
at least one of the cathode and the anode having a resin layer disposed thereon,
the resin layer having an inorganic layer disposed thereon,
the resin layer having a glass transition temperature of 70°C or higher and 200°C or lower and having a coefficient of linear expansion of 9.0 × 10⁻⁶K⁻¹ or greater and 1.5 × 10⁻⁴K⁻¹ or smaller.

2. The solar cell according to claim 1,
wherein the resin layer has a glass transition temperature of 85°C or higher.

3. The solar cell according to claim 1 or 2,
wherein the resin layer contains a resin having an alicyclic skeleton and/or an aromatic skeleton.

4. The solar cell according to claim 3,
wherein the resin having an alicyclic skeleton and/or an aromatic skeleton contains the alicyclic skeleton and/or the aromatic skeleton in an amount of 30% by weight or more.

5. The solar cell according to claim 1, 2, 3, or 4,
wherein the resin layer contains an inorganic filler.
